(19) Europäisches Patentamt
European Patent Office
Office européen des brevets

(11) Publication number: 0 462 704 A1

(12) EUROPEAN PATENT APPLICATION

(21) Application number: 91304598.5

(51) Int. Cl.[5]: G03F 7/021

(22) Date of filing: 21.05.91

(30) Priority: 20.06.90 US 541033

(43) Date of publication of application:
27.12.91 Bulletin 91/52

(84) Designated Contracting States:
BE DE FR GB IT NL

(71) Applicant: MINNESOTA MINING AND MANUFACTURING COMPANY
3M Center, P.O. Box 33427
St. Paul, Minnesota 55133-3427(US)

(72) Inventor: Hedrick, Steven T., c/o Minnesota Mining and
Manufact. Co., 2501 Hudson Road, P.O. Box 33427
St. Paul, Minnesota 55133-3427(US)
Inventor: Larson, Wayne K., c/o Minnesota Mining and
Manufact. Co., 2501 Hudson Road, P.O. Box 33427
St. Paul, Minnesota 55133-3427(US)
Inventor: Lorenz, William J., c/o Minnesota Mining and
Manufact. Co., 2501 Hudson Road, P.O. Box 33427
St. Paul, Minnesota 55133-3427(US)
Inventor: Schneider, Richard A., c/o Minnesota Mining and
Manufact. Co., 2501 Hudson Road, P.O. Box 33427
St. Paul, Minnesota 55133-3427(US)

(74) Representative: Baillie, Iain Cameron et al
c/o Ladas & Parry Isartorplatz 5
W-8000 München 2(DE)

# (54) Photosensitive composition and printing plate.

(57) Disclosed are light-sensitive adducts of a diazonium resin having a plurality of pendant diazonium groups and certain sulfopolyesters having a plurality of sulfo groups. The sulfopolyesters are the product of the esterification reaction of (a) ethylene glycol and at least one branched chain glycol; with (b) at least two dicarboxylic acids independently selected from the group of sulfoarylene dicarboxylic acids; alkyl or alkoxy substituted meta- or para- arylene dicarboxylic acids; unsubstituted, non-ortho- or peri- arylene dicarboxylic acids, and aliphatic dicarboxylic acids. The light-sensitive adducts make excellent coatings for pre-sensitized lithoplates.

EP 0 462 704 A1

## Field of the Invention

This invention relates to a radiation sensitive polymeric adduct of a diazonium resin and an amorphous sulfopolyester polymer. It also relates to photopolymerizable coatings and presensitized lithoplates containing the radiation sensitive adduct.

## Background of the Invention

Lithographic plates (also called lithoplates or printing plates) are sheet-like articles with metal, paper, or plastic substrates that have been cleaned, treated, or coated with a thin film of a radiation or light sensitive material. This material, which is typically a diazonium resin, is naturally soluble in some solvents such as water or halogenated organic compounds but becomes insoluble thereafter when it is dried and exposed to light. A latent photoimage is produced on the plate by placing a negative or positive image in close contact with the coated plate and then exposing the plate to a controlled light source such as ultraviolet light. The light passes through the positive or negative thereby photoinsolubilizing the portions of the coating exposed to light. The portions of the coating which remain shaded by the opaque portions of the negative or positive remain soluble. Afterwards, the plate is usually developed in an alcohol/water developing solution.

Diazonium compounds are well known and widely used to impart light sensitivity to negative acting lithoplates. Upon exposure, the photochemical decomposition of the diazonium salt produces physical and chemical changes such that the exposed areas are rendered selectively insoluble when contrasted with unexposed areas. Typical of the diazonium resins utilized as photosensitive materials are those described in U.S. Pat. No. 2,714,066 which are synthesized by the condensation reaction of an active carbonyl compound and a diazonium compound.

The well known problems in the printing and publishing industry of ink toning and scumming in the background of a lithographic plate associated with the use of just a diazonium resin as a photosensitizer have been addressed by using instead a radiation sensitive adduct of a diazonium resin with a polymer having a plurality of sulfonated groups, as is disclosed in U.S. Pat. Nos. 4,401,743 and 4,408,532.

The use of the aforementioned adducts, however, presents problems in the manufacture of lithographic plates caused by the difficulty of removing the high boiling polar solvents, e.g., dimethylformamide and N-methylpyrrolidone, used to make the coatings of the adduct; by the tendency of the coated plates to block when they are placed in close contact with one another; and by the loss of image areas on the press after they have been stored in a humid environment.

These problems were addressed in U.S. Pat. No. 4,543,315 wherein particular low boiling, solvent soluble adducts of a diazonium resin and an amorphous sulfopolyester are disclosed. Exemplary amorphous sulfopolyesters having utility in the aforementioned patent are described in U.S. Pat. No. 4,480,085. These sulfopolyesters are amorphous, non-crystallizable polyesters possessing pendant sulfo groups and have a preferred weight average molecular weight of from about 8,000 to about 50,000. These sulfopolyesters remain non-crystallizable under annealing conditions due to the fact that at least 35 mole percent of the aromatic ester functionality incorporated in the polyester is derived from either ortho- or peri-substituted carboxylic acids or derivatives thereof.

Whereas the adducts disclosed in U.S. Patent No. 4,543,315 make acceptable photopolymerizable coatings for lithoplates, coatings which exhibit improved performance during both the photoimage transfer and on-line printing processes are continually sought by the printing and publishing industry. Decreased time for photoinsolubilizing of the coating on the lithoplate upon exposure to actinic radiation during production of an insoluble photoimage on the lithoplate is highly desirable in order to decrease production time which is very important to the printer. Additionally, the coated lithoplate or printing plate will be susceptible to degradation by paper lint, solvents, and inks during the on-line printing process and such degradation needs to be minimized as much as possible in order to ensure maximum reuse of the lithoplate.

It was against the above background that Applicants sought to develop a coating for lithoplates which exhibited superior properties, particularly during the photoimage production and on-line printing processes, as compared to more conventional coatings such as those disclosed in U.S. Patent No. 4,543,315.

## Brief Summary of the Invention

By the present invention, Applicants have discovered that radiation sensitive adducts of a diazonium resin having a plurality of pendant diazonium groups and certain sulfopolyesters having a plurality of sulfo groups make excellent coatings for lithoplates. The sulfopolyesters are the product of the esterification

reaction of (A) ethylene glycol and at least one branched chain glycol; with (B) at least two dicarboxylic acids independently selected from the group of sulfoarylene dicarboxylic acids; alkyl or alkoxy substituted meta- or para- arylene dicarboxylic acids; unsubstituted, non-ortho-or non-peri- arylene dicarboxylic acids; and aliphatic dicarboxylic acids.

Also provided by the present invention are novel presensitized lithoplates coated with the light-sensitive adducts. Also provided is a process for developing a photoimage transferred to the presensitized plate.

The radiation sensitive adducts of this invention are distinguishable from those disclosed in U.S. Patent Nos. 4,480,065 or 4,543,315 because the present invention employs meta- or para-arylene dicarboxylic acids to form the sulfopolyester rather than the substantially ortho- or peri-arylene dicarboxylic acids employed in the two foregoing patents. This in turn provides for higher cure rates (photospeeds) when exposed to actinic light for the coatings of the present invention as compared to those disclosed in either 4,480,065 or 4,543,315. Furthermore, the lithoplates of the present invention have higher press lives. Consequently, the novel light-sensitive adducts, coating compositions, and lithoplates of the present invention should be favorably received by the printing and publishing industry.

Other aspects and advantages of the present invention will become apparent from the detailed description, the examples, and the claims.

## Detailed Description of the Invention

Exemplary diazonium resins suitable for use in the invention are described in U.S. Pat. No. 2,714,066 with the preferred resins being the salts of the condensation product of paraformaldehyde and p-phenylaminodiazonium salts. The anion associated with the diazonium resin is not of particular importance, with the exception of solubility characteristics relative to the reactant and coating solvent used.

The sulfopolyesters utilized in the present invention are amorphous, non-crystallizable, and high molecular weight. These sulfopolyesters, as disclosed above, are the esterification reaction product of one or more dicarboxylic acids with ethylene glycol and/or a branched chain glycol.

The term "amorphous and non-crystallizable" as used in this invention means that the sulfopolyester fails to exhibit crystalline regions either when freshly prepared or after having been subjected to annealing conditions for prolonged periods of time, e.g. after a sample of the sulfopolyester has been held at a temperature above its glass transition temperature (50 °C to 150 °C) for from two to ten days. Techniques for examining this phenomenon include thermal techniques, i.e. differential scanning colorimetry and conventional x-ray techniques.

The term "sulfo", as used herein, is intended to embrace the group $-SO_3M$, in which M is an alkali metal cation such as sodium, potassium, and lithium.

The glycols employed in the present invention are ethylene glycol and at least one branched chain glycol, preferably neopentyl glycol.

At least two dicarboxylic acids are utilized in the present invention. They are independently chosen from the group consisting of sulfoarylene dicarboxylic acids such as 3-sulfophthalic acid, 4-sulfophthalic acid, 5-sulfophthalic acid, sulfoterephthalic acid, 4-sulfonapthalene-2,7-dicarboxylic acid,5-(4-sulfophenyl) isophthalic acid, 5-(4-sulfophenoxy) isophthalic acid, 5-(2-sulfoethyl) isophthalic acid, and 5-sulfoisophthalic acid, with the latter preferred; alkyl or alkoxy substituted meta- or para- arylene dicarboxylic acids such as 5-methyl isophthalic acid, and 5-t-butyl isophthalic, with the latter preferred; unsubstituted, non-ortho- or non-peri- substituted arylene dicarboxylic acids such as terepthalic acid, 2,6-napthalenedicarboxylic acid, 1,3-napthalenedicarboxylic acid, 1,4-napthalenedicarboxylic acid, 1,4-napthalenedicarboxylic acid, and isophthalic acid, with the latter preferred; and aliphatic dicarboxylic acids such as adipic acid, succinic acid, glutamic acid, tetradecanedicarboxylic acid, 2,3-dimethyl-1,4-butanedicarboxylic acid, 1,4-cyclohexanedicarboxylic acid, 1,4-cyclohexanediacetic acid, and sebacic acid, with the latter preferred.

The sulfopolyesters used in the adducts of this invention have a molecular weight of from 5,000 to 50,000 and preferably from 30,000 to 50,000. Preferably, the sulfopolyesters are comprised of repeating units of the following formula:

$$-\!\!\left(\overset{\overset{\displaystyle O}{\|}}{C}-R-\overset{\overset{\displaystyle O}{\|}}{C}-O\right)\!\!-(A)-$$

wherein:

R is one or more divalent organic groups selected from the group consisting of $R_3$, $R_4$, $R_5$, and $R_6$;
A is one or more divalent organic groups selected from the group of $R_1$,$O_a$ and $R_2O_b$;
$R_1$ is ethylene;
$R_2$ is a branched chain alkylene group having 3 to 10 carbon atoms, preferably neopentylene;
$R_3$ is an alkyl or alkoxy substituted meta- or para-arylene group, preferably 5-t-butyl phenylene;
$R_4$ is an unsubstituted, non ortho- or peri-substituted arylene group having 6 to 14 carbon atoms, preferably meta- or para-phenylene;
$R_5$ is straight or branched chain alkylene having 2 to 10 carbon atoms; cycloalkylene of 4 to 6 carbon atoms; or cycloalkylene of 3 to 6 carbon atoms with one oxygen atom; and preferably is n-octyl; and
$R_6$ is sulfo-arylene, preferably 5-sulfo-phenylene;

with the proviso that $a + b = 1$; and where $a = .3$ to $.7$ that from 10-90 mole percent of R groups are $R_3$ ; 0-85 mole percent of R groups are $R_4$; 0-85 mole percent of R groups are $R_5$; and 5-25 mole percent of R groups are $R_6$.

The amorphous sulfopolyesters are prepared by the esterification reaction of dicarboxylic acids (or diesters, anhydrides, etc. thereof), with glycols in the presence of acid catalysts, such as antimony trioxide, utilizing heat and pressure as desired. Normally, an excess of glycol is supplied and subsequently removed by conventional techniques during the latter stages of polymerization. When desired, a hindered phenol antioxidant may be added to the reaction mixture to protect the polyester from oxidation.

The amorphous sulfopolyesters provide a sulfo group-containing moiety which, in the metathetical reaction with the diazonium group of the diazonium resin, forms a polymeric salt (called an "adduct" in this application, in which both the positive and negative ions are polymeric) that is soluble in many low boiling solvents and has desirable physical properties, e.g., for lithographic plates, such as flexibility, abrasion resistance, aqueous solvent solubility or dispersibility, and hydrophobicity, i.e., humidity resistance.

The radiation-sensitive polymeric adduct can be prepared by mixing a solution (preferably from about 1 to about 10 percent by weight) of the diazonium resin in water or aqueous alcohol with a solution (preferably from about 1 to about 10 percent by weight) of the sulfopolyester in water or aqueous alcohol, whereupon the polymeric adduct precipitates as a fine particulate solid which can be filtered, washed with water to remove counter ions and dried. Generally, the solutions are prepared so that there is one sulfo group per about 0.2 to about 2.0 diazonium groups, and more preferably about 0.9 to about 1.7 diazonium groups.

The sulfopolyester should contain one sulfo group per about 500 up to about 8,000 molecular weight of polymer, with the preferred range being from about 1,500 to about 3,000 molecular weight.

Presensitized lithographic plates can be prepared by coating a solution of the radiation-sensitive polymeric adduct in a suitable solvent, e.g. methyl ethyl ketone, onto a suitable substrate and removing the solvent to provide a dry coating weight of from about 0.4 to about 2.0 grams per square meter ($g/m^2$), and preferably 0.6 to 1.5 $g/m^2$. Coating weights below about 0.4 $g/m^2$ can provide shortened plate life, increasing with increased coating weights up to about 2.0 $g/m^2$, above which plate life is not noticeably increased.

Where the plate substrate is what is termed "a low energy substrate", e.g., smooth aluminum, a most preferred coating weight is from about 0.4 to about 1.0 $g/m^2$, and where the plate substrate is from a "high energy substrate", e.g., grained and anodized aluminum, the most preferred coating weight is from about 0.8 to about 1.3 $g/m^2$.

Low boiling organic solvents having a boiling point at atmospheric pressure between about 40°C and about 100°C are used in the present invention as the solvent for the light sensitive adduct. Non limiting examples of non-halogenated solvents include methyl ethyl ketone, cyclohexanone, and acetophenenone.

Substrates onto which the radiation-sensitive solutions can be coated to provide a presensitized light sensitive article include sheet materials such as paper, plastic, or metal and preferably, those that are permanently hydrophilic and conventionally used in the preparation of lithographic plates. Aluminum, which has first been cleaned and treated to render it permanently hydrophilic, is the preferred substrate of lithographic constructions. Well-known methods of treatment include silicating, electrolytic anodizing mechanical graining, or combinations thereof. In addition to providing a durable hydrophilic background, the treatment can also influence coating performance characteristics, such as exposure time, ease of development, image adhesion, press life, etc.

The versatility and wide variety of light-sensitive coating compositions made possible by this invention allow one to select or arrive at preferred combinations of base and coating to achieve optimum performance.

The radiation-sensitive solution of polymeric adduct can contain modifying additives such as a thermoplastic polymer to modify or improve the physical properties of the coating. For example, properties

such as developer solubility, abrasion resistance, ink receptivity, press life, etc., can be influenced by the addition of thermoplastic polymer in amounts up to about 30 percent by weight. Suitable polymers include the sulfopolyesters, other sulfonated polymers such as sulfonated polyurethanes, polyvinyls, pyrrolidones, nylons, vinylidene chloride copolymers, polyvinyl esters, polyacrylates, and alpha-alkyl polyacrylates, polyvinyl chlorides, e.g., 86 percent/14 percent vinyl chloride vinylacetate copolymer commercially available as "VYHH$^{R}$" from Union Carbide, polyvinyl acetals, polyvinyl alcohols, and cellulose acetate butyrate, among others. The amounts and type of resin added to improve the formulation depends upon the specific property being altered and can be arrived at empirically.

Presensitized articles are typically formulated with pigments or dyes to facilitate manufacturing control and visual appearance of the product, as well as to aid in using the article relative to positioning, developing, etc. Pre-dispersed pigments such as "Microlith" Series (tradenames for pigments pre-dispersed in a vinyl resin, commercially available from Ciba Geigy) are useful at from about 5 to 20 weight percent of the coating. Pigments such as "Monastral Blue" and "Microlith Purple" (commercially available from Ciba Geigy) can also be used in the same general concentration range using standard milling dispersion techniques. Dyes such as triphenyl methane dyes, e.g., "Victoria Blue BO", commercially available from E.I. du Pont are also useful as coloring agents, preferably at from about 0.5 to 5 percent by weight of the coating.

Dyes which provide a visible image upon exposure to actinic radiation may also be incorporated in the formulation to aid a user in visualizing the exposed article prior to development. Conventional well-known leuco dye and acid-base dye printout systems can be utilized. An exemplary material is 4-(phenylazo)-diphenylamine, which can be used at from about 0.25 to 2 percent by weight of the coating.

Organic solvent-soluble diazonium salts can also be incorporated into a solution of the light-sensitive polymeric adduct to provide printing plates which provide printed copies having improved acuity. Up to about 5 percent by weight of the organic solvent-soluble diazonium salt, based on the weight of adduct, can be effectively used. Examples of such soluble salts are the organic sulfonate salts of diazonium salts such as 4-toluene diazonium toluenesulfonate and the condensation product of formaldehyde and 4-phenylaminobenzenediazonium triisopropylnaphthalenesulfonate (TINS).

In addition, photopolymerizable components may be incorporated into the formulation to enhance the solubility difference between image and non-image areas. Unsaturated polyfunctional monomeric or oligomeric compounds, which can be polymerized under the influence of light, include acrylic esters, acrylamides, etc., which can be used at concentrations of up to about 50 percent by weight of total solids.

Preferably, a photoinitiator is included in the photopolymer formulation at from about 1 to 5 percent by weight of the coating. Preferred photoinitiators include the chromophore-substituted vinyl-halomethyl-s-triazines disclosed in U.S. Pat. No. 3,987,037.

It is preferred that the radiation-sensitive solution be coated onto a substrate that has been primed by a thin (i.e., 0.5 to 15 mg/m$^2$) layer of a subbing compound such as cellulose acetate, particularly hydrolyzed polyvinyl alcohol, or an aqueous solvent-soluble polymeric diazonium compound, e.g., the chloride or zinc chloride double salt of aldehyde condensation products of p-azodiphenylamine such as is described in U.S. Pat. No. 2,714,066. With the latter subbing compound, excess sulfonated polymer can be used, wherein the sulfopolyester combines with the diazonium layer to provide desensitization of the background without necessity of added desensitizing salts in the developer Improved humidity resistance has also been noticed.

Developers useful for developing the exposed composition include aqueous solutions of water soluble organic solvents and, optionally, buffers, desensitizers, surfactants, stabilizers and gums. Exemplary water soluble organic solvents for use in developers include ethanol, 1-propanol, 2-propanol, benzyl alcohol and 2-methoxyethanol, and can be used at a concentration of from about 2 to about 40 percent by weight depending on the alcohol selected and its solvent power. For example, the concentration of 1-propanol or 2-propanol at 20 to 40 percent by weight is preferred, whereas that preferred for benzyl alcohol is from about 2 to about 5 percent by weight. Other water-miscible solvents which can be used include ethylene glycol diacetate and butyrolactone.

The addition of anionic surfactants or desensitizing salts to an alcohol/water solution results in the most efficient developer system.

Exemplary anionic surfactants include sodium dodecylbenzenesufonate, dimethylsodiumsulfoisophthalate, sodium lauryl sulfate, dioctyl sodium sulfosuccinate and sodium alkyl naphthalene sulfonate.

Exemplary desensitizing salts include ammonium sulfite, sodium sulfite, etc. The surfactant or desensitizing salt can be used in a concentration of from about 0.5 to 10 percent by weight, and preferably, from about 0.5 to 2.0 percent by weight of the developer solution.

The invention will now be more specifically described by the use of the following non-limiting examples, wherein all parts are by weight unless otherwise specified.

Example 1

Preparation of Sulfopolyester "A"

Into a 1 gallon pressure vessel equipped with a high torque stir, reflux column, and means for maintaining an atmosphere of nitrogen over the contents of the vessel, were added 622.8 g (2.1 moles) dimethyl 5-sodiosulfoisophthalate, 1836.8 g (9.5 moles) dimethyl isophthalate, 2188.2 g (21.0 moles) neopentyl glycol, 1304.5 g (21.0 moles) ethylene glycol, 0.98 cobalt acetate, 12.5 g triethyl amine, and 3.0 g antimony trioxide. The vessel was then sealed and pressurized to 20 psi. While stirring, the mixture was heated to 245 °C over a period of 45 minutes, during which time methanol evolution was observed. The vessel was then cooled, depressurized, and 637.5 g (3.2 moles) sebacic acid, and 1401.3 g (6.3 moles) t-butyl isophthalic acid were added. The vessel was then repressurized to 50 psi, and heated with stirring to 260 °C over a period of 40 minutes, during which time evolution of water was observed. The pressure was then reduced to 0.2 torr, and the temperature gradually increased to 275 °C over a period of 2 hours. After this time, an extremely viscous clear resin was discharged hot from the vessel as a high molecular weight sulfopolyester containing 10 mole % sulfoisophthalate, 45 mole % isophthalate, 15 mole % sebacate, 30 mole % 5-t-butyl isophthalate, 36 mole % ethylene esters, 61 mole % neopentyl esters, and 3 mole % diethylene glycol esters. The sulfopolyester had a sulfo equivalent weight of ~2500, a glass transition, $T_g$, of 47 °C, and a molecular weight (determined by gel permeation chromatography) $M_w$ of ~40,000. No evidence of crystallinity was observed by differential scanning calorimetry in a sample annealed at 100 °C for 72 hours. The sulfopolyester was completely soluble in methyl ethyl ketone as well as in water/isopropanol (90/10).

Example 2

Preparation of Sulfopolyester "B"

Into a 4.5 liter pressure vessel equipped with a high torque stir, reflux column, and means for maintaining an atmosphere of nitrogen over the contents of the vessel, were added 101.9 g (0.4 moles) 5-sodisulfoisophthalic acid, 1073.3 g (6.5 moles) terephthalic acid, 168.9 (0.8 moles) 5-tert-butyl isophthalic acid, 660.3 g (10.7 moles) ethylene glycol, 395.6 g (3.8 moles) neopentyl glycol, 2.04 g sodium acetate, and 0.67 g antimony trioxide. The vessel was then sealed, and pressurized to 40 psi with nitrogen. While stirring, the mixture was heated to 250 °C over a period of approximately 80 minutes, over which time water evolution was observed. The pressure was then gradually reduced to 1.0 torr and the mixture polymerized for approximately 2 hours, with the temperature gradually increased up to 280 °C. After this time the polymer was discharged from the vessel as an extremely viscous, clear liquid. This high molecular weight sulfopolyester contained 5 mole % 5-sulfoisophthalate, 10 mole % 5-t-butyl isophthalate, 85 mole % terephthalate, 29.7 mole % neopentyl esters, 65.1 mole % ethylene esters, and 5.3 mole % diethylene glycol, with a sulfonate equivalent weight of approximately 4350. The polyester was soluble in hot MEK/$H_2O$ 95/5), and in $H_2O$/isopropanol (70/30).

Example 3

Preparation of Sulfopolyesters "C-L"

Other amorphous sulfopolyesers were prepared by the procedure of Sulfopolyester "A" or "B" using the reactants and amounts shown in Table I. The sulfo equivalent weight of each sulfopolyester is also shown.

| | |
|---|---|
| DMSSIP - | dimethyl 5-sodiosulfoisophthalate |
| DMI - | dimethyl isophthalate |
| DMT - | dimethyl terephthalate |
| 5-tBIA - | 5-tert-butyl isophthalic acid |
| SA - | sebacic acid |
| EG - | ethylene glycol |
| NPG - | 2,2-dimethyl-1,3-propanediol |

TABLE I

| SULFO-POLY-ESTER | MOLE PERCENT OF MONOMER | | | | | MOLE PERCENT | | $-SO_3Na$ EQUIV WT |
|---|---|---|---|---|---|---|---|---|
| | DMSSIP | DMT | DMI | 5-TBIA | SA | EG | NPG | |
| C | 5 | 25 | | 50 | 20 | 100 | 100 | 5066 |
| D[a] | 5 | 80 | | 15 | | 160 | 40 | 4110 |
| E | 8 | | 47 | 30 | 15 | 100 | 100 | 3042 |
| F | 9 | | 46 | 30 | 15 | 100 | 100 | 2715 |
| G[a] | 10 | | 45 | 30 | 15 | 180 | 100 | 2394 |
| H[a] | 10 | | 45 | 30 | 15 | 180 | 150 | 2535 |
| I | 10 | 28 | 25 | 25 | 17 | 80 | 80 | 2426 |
| J | 16 | | 49 | 20 | 15 | 100 | 100 | 1537 |
| K | 20 | | 75 | 5 | | 100 | 100 | 1181 |
| L | 25 | 20 | | 40 | 15 | 100 | 100 | 1065 |

a) Reaction run using dicarboxylic acid starting materials instead of dimethyl esters as shown.

Example 4

Preparation of Adduct of Sulfopolyesters "A-L" with a Diazonium Resin

Five grams of ketone soluble amorphous sulfopolyester A (containing 2.0 milliequivalent of sulfo group) were dissolved in 90:10 water, n-propyl alcohol at 60° C. The solution was cooled to 40° C and while stirring 64 ml of a 1% aqueous solution (1.0 meg) of the zinc chloride double salt of the formaldehyde condensation product of p-diazodiphenylamine (designated "R diazo") was added. A tan finely divided solid precipitate was obtained immediately that was filtered, washed with water and dried. The precipitate could be stored for later use or immediately dissolved and coated. This procedure was followed to prepare "diazo adducts" from each of the amorphous sulfopolyesters B through L. In addition, the ratio of diazonium resin to amorphous sulfopolyester was examined with the most useful ratios being one sulfo group per .9 to about 1.5 diazonium groups.

Example 5

A photosensitive composition useful for coating various substrates and in particular, a formulation prepared for use in a lithographic plate contruction was made using the following components:

| | |
|---|---|
| The adduct of 1:1 equivalents of sulfopolyester "A" and "R" diazonium resin | 1.0 |
| Victoria Blue B.O. dye | .2 |
| Methyl ethyl ketone | 18.8 |

The composition was coated at about .8 grams/m$^2$ onto grained, anodized and silicated aluminum to provide

a presensitized lithogaphic printing plate. Storage of the plate in a high humidity environment or at an elevated temperature had no noticeable affect. The photo sensitive lithographic plate was exposed through a negative film stencil to actinic radiation on a commercial ultraviolet emitting exposure frame. The timed exposure required to obtain optimum performance compared to the article described in U.S. Patent No. 4,543,315 is reduced by 30%. The unexposed coating was then removed with a developer solution consisting of water containing 3.5% by weight benzyl alcohol, 2.0% by weight ammonium sulfite and 2.0% by weight sodium naphthalene sulfonate with buffers as necessary for pH 7.0.

Example 6

A photosensitive composition useful for coating a lithographic layer on treated aluminum was prepared with the following components:

| | |
|---|---|
| The adduct of 1:1.5 equivalence of sulfopolyester "A" and "R" diazonium resin | .605 |
| Sulfopolyester "A" | .17 |
| Cellulose acetate butyrate resin | .06 |
| Vinyl/pigment millbase | .16 |
| 4-(phenylazo) diphenylamine | .005 |
| Methyl ethyl ketone | 19.000 |

The composition was coated at about 1.60 g/m$^2$ onto a grained, anodized and silicated aluminum sheet which had been previously primed with "R" diazo resin to about 0.05 to 0.15 mg/m$^2$. The sheet was dried one minute at 180$^\circ$ F to remove solvent. The coated sheet was exposed to actinic radiation on a commercial ultraviolet emitting exposure frame. The light exposure required to obtain optimum performance compared to the article described in U.S. Patent No. 4,543,315 is reduced by 30 to 50%. The unexposed coating was then removed with a developer solution consisting of water containing 3.5% by weight benzyl alcohol, 2.0% by weight ammonium sulfite and 2% by weight sodium napthaline sulfonate with buffers as necessary for pH 7.0. The developed offset plate was mounted on a Miehle 29 offset printing press. Results of comparison to a control plate of U.S. Patent No. 4,543,315 show increased press life to 150%.

Reasonable modifications and variations are possible from the foregoing disclosure without departing from the spirit or scope of the present invention.

## Claims

1. A light-sensitive adduct comprising the combination of a diazo resin having a plurality of pendant diazonium groups and an amorphous sulfopolyester having a plurality of sulfo groups, said sulfo polyester comprising the product of the esterification reaction of (a) ethylene glycol and at least one branched chain glycol; with (b) at least two dicarboxylic acids independently selected from the group of sulfoarylene dicarboxylic acids; alkyl or alkoxy substituted meta- or para- arylene dicarboxylic acids; unsubstituted, non-ortho- or non-peri- arylene dicarboxylic acids; and aliphatic dicarboxylic acids, said adduct being formed from the metathetical reaction of sulfo group-containing moieties of said sulfopolyester and said diazonium groups.

2. The adduct of Claim 1 wherein said sulfopolyester is comprised of repeating units of the formula:

$$-\left( \overset{\overset{O}{\|}}{C}-R-\overset{\overset{O}{\|}}{C}-O \right)-(A)-$$

wherein:

$R$ is one or more divalent organic groups selected from the group consisting of $R_3$, $R_4$, $R_5$, and $R_6$;

$A$ is one or more divalent organic groups selected from the group of $R_1O_a$ and $R_2O_b$;

$R_1$ is ethylene;

$R_2$ is a branched chain alkylene group having 3 to 10 carbon atoms;

$R_3$ is an alkyl or alkoxy substituted meta- or para-arylene group;

$R_4$ is an unsubstituted, non ortho- or peri-substituted arylene group having 6 to 14 carbon atoms;

$R_5$ is straight or branched chain alkylene having 2 to 10 carbon atoms; cycloalkylene of 4 to 6 carbon atoms; or cycloalkylene of 3 to 6 carbon atoms with one oxygen atom; and

$R_6$ is sulfo-arylene,

with the proviso that $a+b=1$; and where $a=.3$ to .7 that from 10-90 mole percent of R groups are $R_3$; 0-85 mole percent of R groups are $R_4$; and 0-85 mole percent of R groups are $R_5$; and 5-25 molepercent of R groups are $R_6$.

**3.** A light-sensitive adduct according to Claim 2 wherein:

$R_2$ is neopentylene;

$R_3$ is 5-t-butyl phenylene;

$R_5$ is n-octyl; and

$R_6$ is 5-sulfo-arylene.

**4.** A light-sensitive adduct according to Claim 1 wherein said sulfopolyester contains one sulfo group per about 500 to about 8000 molecular weight.

European Patent Office

# EUROPEAN SEARCH REPORT

Application Number

**EP 91 30 4598**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 136 903 (3M)<br>* page 13, line 17 - page 14, line 7; claims *; US - A - 4543315 | 1-4 | G 03 F 7/021 |
| Y | DE-A-3 345 902 (CASSELLA AG)<br>* claims; page 6, lines 20-24 * | 1-4 | |
| D,A | US-A-4 401 743 (J.H. INCREMONA)<br>* claims; column 6, lines 26-56 * | 1-4 | |

TECHNICAL FIELDS SEARCHED (Int. Cl.5)

G 03 F 7/00
C 08 G 63/00

The present search report has been drawn up for all claims

| Place of search | Date of completion of search | Examiner |
|---|---|---|
| Berlin | 13 September 91 | STOCK H |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document